# FASCICULE DE BREVET EUROPEEN

(11) **EP 3 055 439 B1**
(45) Date de publication et mention de la délivrance du brevet: **05.06.2019**
(21) Numéro de dépôt: 13773326.7
(22) Date de dépôt: 01.08.2013
(51) Int. Cl.: C23C 28/00, C23C 14/16, C23C 14/56, C23C 14/24, B32B 15/01, C22C 38/00, C22C 38/02, C22C 38/04, C22C 38/06, C22C 38/14, C22C 38/18, C22C 38/38

(54) **TÔLE D'ACIER MUNIE D'UN REVÊTEMENT DE ZINC**
STAHLBLECH, VERSEHEN MIT EINEM ZINKÜBERZUG
STEEL SHEET PROVIDED WITH A ZINC COATING

(43) Date de publication de la demande: 17.08.2016
(73) Titulaire: Arcelormittal, 1160 Luxembourg (LU)
(72) Inventeur: CHALEIX, Daniel, F-57420 Verny (FR); CAPITANI, Isabelle, F-57920 Monneren (FR); SILBERBERG, Eric, Haltinne (Gesves) (BE); PACE, Sergio, B-1370 Jodoigne (BE); SCHMITZ, Bruno, B-4550 Nandrin (BE); VANDEN EYNDE, Xavier, B-4261 Latinne (Braives) (BE)
(74) Mandataire: Lavoix
(86) Numéro de dépôt international: PCT/IB2013/001681
(87) Numéro de publication internationale: WO 2015/015237

(56) Documents cités:
- EP-A1- 0 630 987
- SCHMITZ B ET AL: ""Jet Vapor Deposition", a novel vacuum coating technique with superior properties / JVD : un nouveau procédé de revêtement sous vide pour des produits à propriétés améliorées", REVUE DE MÉTALLURGIE - CAHIERS D'INFORMATIONS TECHNIQUES, vol. 97, no. 7/8, juillet 2000 (2000-07), pages 971-978, XP000976084, Revue de Métallurgie, Paris [FR] ISSN: 0035-1563

## Description

La présente invention est relative à une tôle d'acier munie d'un revêtement comprenant une couche de zinc éventuellement recouverte de peinture, qui est plus particulièrement destinée à la fabrication des pièces pour l'automobile, sans pour autant y être limitée.

Les revêtements galvanisés comprenant essentiellement du zinc sont traditionnellement utilisés pour leur bonne protection contre la corrosion, que ce soit dans le secteur automobile ou dans la construction, par exemple.

Dans la suite du texte on entendra par revêtement de zinc un revêtement de zinc pur, éventuellement constitué d'impuretés inévitables lors de la production et présentes en quantité de traces.

Les bobines d'acier ainsi revêtues peuvent parfois séjourner dans des hangars de stockage pendant plusieurs mois et ne doivent pas voir leur surface s'altérer par l'apparition d'une corrosion de surface avant d'être mises en forme par l'utilisateur final. En particulier, aucune amorce de corrosion ne doit apparaître quel que soit l'environnement de stockage, même en cas d'exposition au soleil et/ou à un environnement humide voire salin. Une couche d'huile de protection peut ainsi être appliquée sur la surface de la bobine d'acier afin d'assurer une protection temporaire en cas de stockage dans un environnement humide.

Les procédés les plus utilisés pour réaliser le dépôt d'un revêtement de zinc sur la surface d'une tôle d'acier sont la galvanisation ou l'électrozingage. Mais ces procédés classiques ne permettent pas de revêtir des nuances d'aciers riches en éléments oxydables tels que Si, Mn, Al, P, Cr ou B, ce qui a conduit à développer de nouveaux procédés de revêtements, et notamment des technologies de dépôt sous vide telle que le dépôt sous vide par jet de vapeur sonique(JVD).

Cependant, ces revêtements sous vide n'ont pas le même niveau de protection temporaire que les revêtements classiques même après application d'une couche d'huile de protection.

La publication de
SCHMITZ B ET AL: ""Jet Vapor Déposition", a novel vacuum coating technique with superior properties /JVD : un nouveau procédé de revêtement sous vide pour des produits à propriétés améliorées", LA REVUE DE MÉTALLURGIE - CAHIERS D'INFORMATIONS TECHNIQUES, vol. 97, no. 7/8, juillet 2000, pages 971 - 978, XP976084, Revue de Métallurgie, Paris [FR] ISSN: 0035-1563 décrit un développement de procédé de dépôt physique en phase vapeur, dit "procédé JVD (Jet Vapor Déposition)", pour revêtir des tôles d'acier avec une couche de Zn pur ou de Zn-Mg ou Al.

Le but de la présente invention est donc de remédier aux inconvénients des aciers revêtus de l'art antérieur en mettant à disposition une tôle d'acier revêtue de zinc par dépôt sous vide présentant une bonne protection temporaire contre la corrosion.

A cet effet, l'invention a pour premier objet une tôle d'acier selon la revendication 1.

La tôle peut également comprendre les caractéristiques des revendications 2 à 5 prises isolément ou en combinaison.

L'invention a également pour objet un procédé selon la revendication 6.

Le procédé peut également comprendre les caractéristiques des revendications 7 à 8, prises isolément ou en combinaison.

D'autres caractéristiques et avantages de l'invention apparaîtront à la lecture de la description qui va suivre.

Afin d'illustrer l'invention, des essais ont été réalisés et vont être décrits à titre d'exemples non limitatifs, notamment en référence aux figures qui représentent :
- La figure 1 représente une installation de dépôt JVD permettant de mettre en oeuvre le procédé selon l'invention
- La figure 2 est une photographie échelle 1 d'une tôle revêtue selon l'art antérieur.
- La figure 3 est une photographie échelle 1 d'une tôle revêtue selon l'invention.

La tôle revêtue selon l'invention comprend tout d'abord un substrat en acier, de préférence laminé à chaud puis laminé à froid pour pouvoir être utilisée pour la fabrication de pièces de carrosserie pour l'automobile. L'invention n'est pas pour autant limitée à ce domaine et peut trouver un emploi pour toute pièce en acier quel que soit son usage final.

Le substrat en acier peut notamment par exemple être l'une des nuances d'acier THR (Très Haute Résistance, généralement comprise entre 450 et 900 MPa) ou UHR (Ultra Haute Résistance, généralement supérieure à 900 MPa) suivantes qui sont riches en éléments oxydables:
- aciers sans éléments interstitiels (IF-Interstitial Free), qui peuvent contenir jusqu'à 0,1% en poids de Ti;
- aciers dual-phase tels que les aciers DP 500 jusqu'aux aciers DP 1200 qui peuvent contenir jusqu'à 3% en poids de Mn en association avec jusque 1% en poids de Si, Cr et/ou Al,
- aciers TRIP (TRansformation Induced Plasticity) tel que l'acier TRIP 780 qui contient par exemple environ 1,6% en poids de Mn et 1,5% en poids de Si;
- aciers TRIP ou dual-phase contenant du phosphore;
- aciers TWIP (TWining induced plasticity) - aciers ayant une forte teneur en Mn (généralement 17-25% en poids),
- aciers à basse densité tels que les aciers Fe-Al qui peuvent contenir par exemple jusqu'à 10% en poids de Al ;
- aciers inoxydables, qui ont une forte teneur en chromes (généralement 13-35% en poids), en association avec d'autres éléments d'alliage (Si, Mn, Al...)

La tôle d'acier pourra éventuellement être revêtue d'une ou plusieurs couches en complément de la couche de zinc de manière adaptée aux propriétés souhaitées du produit final. La couche de zinc sera de préférence la couche supérieure du revêtement.

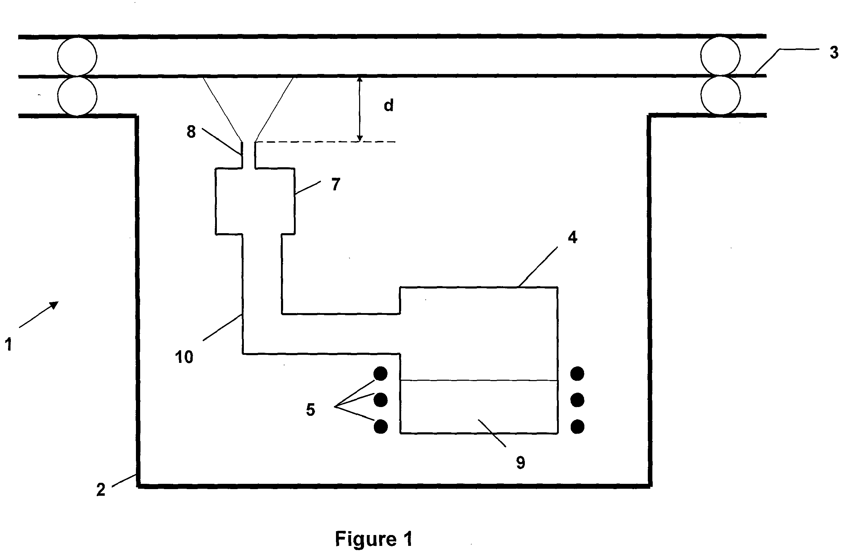

Un procédé de fabrication d'une tôle d'acier selon l'invention est représenté plus particulièrement en figure 1, sur laquelle on peut voir une installation 1 comprenant une chambre de dépôt sous vide 2. Cette chambre comprend un sas d'entrée et un sas de sortie (non représentés), entre lesquels circule la tôle d'acier 3 à revêtir. Le défilement de la tôle 3 peut se faire par tous moyens adaptés, par exemple un rouleau support rotatif sur lequel peut s'appuyer la bande.

Placée en regard de la surface de la bande à revêtir se trouve une chambre d'éjection 7 munie d'une fente 8, la partie supérieure de la fente 8 étant placée à une distance d de la surface de la bande à revêtir comprise par exemple entre 20 et 60 mm. Cette chambre 7 est montée sur un creuset d'évaporation 4 qui contient le zinc liquide 9 à déposer sur la surface de la bande d'acier 3. Le creuset d'évaporation 4 est avantageusement muni d'un dispositif de chauffage par induction 5 permettant à la vapeur de se former. La vapeur s'échappe alors du creuset par une conduite 10 qui l'amène vers la chambre d'éjection 7, et la fente 8, de préférence calibrée, de manière à former un jet dirigé vers la surface du substrat à revêtir. La présence de la fente 8 permet la régulation du débit massique de vapeur, à une vitesse sonique constante le long de la fente (col sonique), ce qui procure l'avantage d'obtenir un dépôt uniforme. On se référera par la suite à cette technique en utilisant l'acronyme " JVD " (pour Jet Vapor Déposition). Des informations additionnelles sur cette technique sont notamment décrites dans le brevet EP07447056.

Dans un autre mode de réalisation non représenté le creuset et la chambre d'éjection ne sont qu'une seule et même pièce, comprenant une fente dirigée vers la surface du substrat à revêtir. Dans ce mode de réalisation la vapeur créée par chauffage du bain de zinc remonte directement vers la fente et forme un jet dirigé vers la surface du substrat à revêtir.

La pression P_{chbre} dans la chambre de dépôt 2 et la pression P_{eject} dans la chambre d'éjection 7 sont maintenues de telle sorte que le ratio P_{chbre} sur P_{eject} est compris entre 2.10⁻³ et 5,5.10⁻².

La pression dans la chambre de dépôt 2 est éventuellement maintenue à une pression comprise entre 6.10⁻² mbar et 2.10⁻¹ mbar, afin d'améliorer l'aspect de surface du revêtement.

Une couche d'huile est ensuite appliquée sur la surface de la tôle ainsi revêtue afin d'assurer une protection temporaire en cas de stockage dans un milieu humide et/ou salin avant la livraison ou la transformation en produit final.

La tôle 3, ayant subie ou non une étape dite de skin-pass, peut ensuite être découpée puis mise en forme, par exemple par emboutissage, pliage ou profilage, pour former une pièce que l'on peut ensuite mettre en peinture pour former, sur le revêtement, un film de peinture .

L'invention va à présent être explicitée par des essais réalisés à titre indicatif et non limitatif.

### Tests

### Corrosion de surface

Le test pratiqué est également appelé « test humidotherme » et se pratique dans une chambre climatique selon la norme DIN EN ISO 6270-2.

La protection temporaire contre la corrosion peut être évaluée sur des panneaux plans simulant une tôle lors du stockage ou du transport, ou sur des panneaux déformés représentant une pièce métallique (par exemple une porte de voiture) emboutie à un endroit et transportée à un autre.

Chaque panneau à tester est dégraissé puis enduit sur les deux faces avec une huile appropriée à l'aide d'un appareil d'huilage par aspersion selon la norme ISO 6270-2. Les panneaux sont huilés à l'aide de Fuchs Anticorit RP 4107s, Fuchs 3802/395 ou Zeller PL61 à 1,2 g/m² lorsque le test est effectué pour un constructeur allemand ou à l'aide de Quaker Ferrocoat N 6130 à 1,2 g/m² ±0,3g/m² lorsque le test est effectué pour un constructeur français. Ceux-ci sont laissés non assemblés et non peints.

Une série de cycles de vieillissement de 24 heures est ensuite appliquée aux panneaux, chaque cycle incluant :
- 8 heures à 40°C±3°C et environ 100% d'humidité relative (chambre climatique fermée, y compris durant la chauffe), puis
- 16 heures entre 18°C et 28°C et à l'humidité ambiante (chambre climatique ouverte ou ventilée, y compris durant le refroidissement).

A la fin de la série de cycles, la modification de l'aspect de surface des panneaux est évaluée en terme de pourcentage de la surface ayant été altérée.

La proportion de modification de l'aspect de surface doit être inférieure à 10% après 10 cycles pour les échantillons traités avec l'huile Quaker ou après 15 cycles pour les échantillons traités avec l'une des huiles Fuchs ou l'huile Zeller.

### Essais

On réalise quatre séries de quatre échantillons de tôle d'acier IF laminée à froid de type DC06 tel que commercialisé par ArcelorMittal, comprenant un revêtement de zinc d'une épaisseur de 7,5 µm. Ce revêtement a été déposé par un procédé de dépôt sous vide par jet de vapeur sonique.

Pour chacun des échantillons le revêtement a été effectué avec un ratio différent de pression entre la pression dans la chambre de dépôt P_{chbre} et la pression dans la chambre d'éjection P_{eject}. La distance d entre la partie supérieure de la fente 8 de la chambre d'éjection et la surface de la bande à revêtir est identique et égale à environ 35mm, et la pression au sein de la chambre d'éjection 7 d'environ 3,4 mbar. Les échantillons ainsi revêtus sont ensuite recouverts d'huile de protection, puis soumis à un certain nombre de cycles.

Les essais sont menés pour 10 ou 15 cycles en fonction du type d'huile appliquée mais sont interrompus avant la fin desdits 10 ou 15 cycles si la dégradation de surface est complète.

**Tableau 1**

| Echantillon | Type d'huile |
|---|---|
| 1 | Quaker 6130 - 1,5 g/m² |
| 2 | Fuchs 4107 S - 1,2 g/m² |
| 3 | Fuchs 3802/39 S - 1,2 g/m² |
| 4 | Zeller Gmelin - 1,2 g/m² |

On les soumet ensuite aux tests de corrosion de surface, les résultats sont rassemblés dans le tableau 2, le ratio mentionné étant le ratio entre la pression P_{chbre} dans la chambre de dépôt et la pression P_{eject} dans la chambre d'éjection:

**Tableau 2**

| Echantillon | Ratio P_{chbre}/P_{eject} | | | |
|---|---|---|---|---|
| | 2,9.10⁻⁵ | 1,73.10^{-2*} | 3,23.10^{-2*} | 8,8.10⁻² |
| 1 | 100% après 6 cycles | < 10% après 10 cycles | < 10% après 10 cycles | 100% après 3 cycles |
| 2 | 20% après 15 cycles | < 10% après 15 cycles | < 10% après 15 cycles | 100% après 15 cycles |
| 3 | / | < 10% après 15 cycles | < 10% après 15 cycles | / |
| 4 | / | < 10% après 15 cycles | < 10% après 15 cycles | / |

| | | | | |
|---|---|---|---|---|
| * : selon l'invention | | | | |

On constate que les tôles revêtues selon l'invention présentent une bonne résistance à la corrosion de surface par rapport à une tôle n'ayant pas été revêtue selon l'invention.

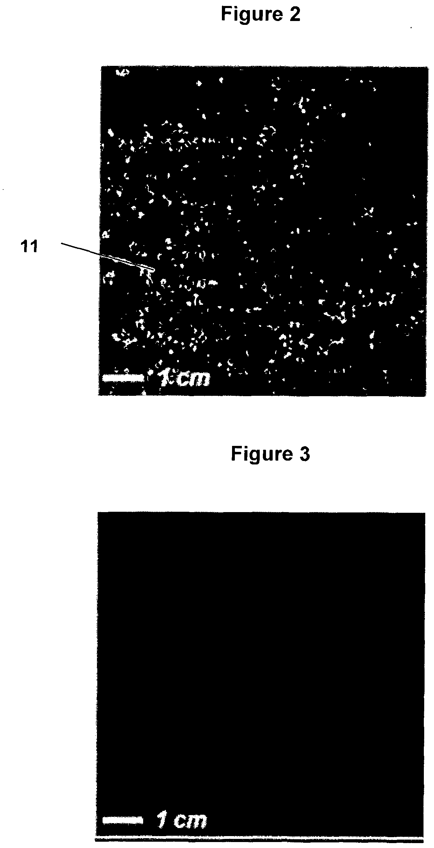

La figure 2 est une photographie à l'échelle 1 de l'échantillon n°1, revêtu avec un ratio de pression de 2,9.10⁻⁵, après six cycles de vieillissement tels que décrits précédemment. On peut voir sur la figure que l'ensemble de la surface de la tôle est altérée 11 après six cycles.

La figure 3 est une photographie à l'échelle 1 de l'échantillon n°1 comme précédemment mais revêtu avec un ratio de pression de 3,23.10⁻², après dix cycles de vieillissement tels que décrits précédemment. On peut voir sur la figure que la surface de la tôle n'est quasiment pas altérée.

## Revendications

1. Tôle d'acier 3 munie d'un revêtement comprenant au moins une couche de zinc obtenue par un procédé de revêtement par dépôt sous vide par jet de vapeur sonique dans une installation 1 comprenant une chambre de dépôt 2 et une chambre d'éjection 7 munie d'une fente 8, dans lequel le ratio entre la pression à l'intérieur de la chambre de dépôt 2 P_{Chbre} et la pression à l'intérieur de la chambre d'éjection 7 du zinc P_{eject} est compris entre 2.10⁻³ et 5,5.10⁻².

2. Tôle d'acier 3 selon la revendication 1 obtenue par un procédé selon lequel la chambre de dépôt 2 est maintenue à une pression P_{Chbre} comprise entre 6.10⁻² mbar et 2.10⁻¹ mbar.

3. Tôle d'acier 3 selon la revendication 1 ou 2 obtenue par un procédé selon lequel la distance d entre la partie supérieure de la fente 8 de la chambre d'éjection 7 et la tôle d'acier 3 à revêtir est comprise entre 20 et 60 mm.

4. Tôle d'acier 3 selon l'une quelconque des revendications 1 à 3 selon laquelle la couche de zinc est la couche supérieure du revêtement.

5. Tôle d'acier 3 selon l'une quelconque des revendications précédentes dans laquelle l'acier revêtu est un acier à Très Haute Résistance.

6. Tôle d'acier 3 selon l'une quelconque des revendications précédentes obtenue par un procédé dans lequel la chambre de dépôt 2 comprend un sas d'entrée et un sas de sortie entre lesquels circule la tôle d'acier à revêtir.

7. Tôle d'acier 3 selon l'une quelconque des revendications précédentes obtenue par un procédé dans lequel la chambre d'éjection 7 est contenue à l'intérieur de la chambre de dépôt 2.

8. Tôle d'acier 3 selon l'une quelconque des revendications précédentes obtenue par un procédé dans lequel la chambre d'éjection 7 est placée en regard de la surface de la tôle d'acier à revêtir.

9. Procédé de fabrication d'une tôle d'acier 3 revêtue qui comprend le revêtement de ladite tôle 3 par un jet de vapeur sonique de zinc par l'intermédiaire d'une chambre d'éjection 7 munie d'une fente 8, ladite chambre d'éjection 7 étant maintenue à une pression P_{eject} et contenue à l'intérieur d'une chambre de dépôt 2 maintenue à une pression P_{Chbre}, le ratio des pressions P_{Chbre} par P_{eject} étant compris entre 2.10⁻³ et 5,5.10⁻².

10. Procédé selon la revendication 9, dans lequel la chambre de dépôt 2 est maintenue à une pression P_{Chbre} comprise entre 6.10⁻² mbar et 2.10⁻¹ mbar.

11. Procédé de fabrication selon la revendication 10 dans lequel la distance d entre la partie supérieure de la fente 8 de la chambre d'éjection 7 et la tôle d'acier 3 à revêtir est comprise entre 20 et 60 mm.

12. Procédé de fabrication selon l'une quelconque des revendications 9 à 11, dans lequel la chambre de dépôt 2 comprend un sas d'entrée et un sas de sortie entre lesquels circule la tôle d'acier à revêtir.

13. Procédé de fabrication selon l'une quelconque des revendications 9 à 11, dans lequel la chambre d'éjection 7 est placée en regard de la surface de la tôle d'acier à revêtir.

## Patentansprüche

1. Stahlblech 3, das mit einer Beschichtung versehen ist, die aufweist wenigstens eine Zinkschicht, die erlangt ist durch ein Verfahren zum Beschichten durch Vakuumabscheidung via Schalldampfstrahl in einer Einrichtung 1, die aufweist eine Abscheidungskammer 2 und eine Ausstoßkammer 7, die mit einem Schlitz 8 versehen ist, wobei das Verhältnis zwischen dem Druck im Inneren der Abscheidungskammer 2 P_{Chbre} und dem Druck im Inneren der Ausstoßkammer 7 des Zinks P_{eject} zwischen 2.10⁻³ und 5,5.10⁻² liegt.

2. Stahlblech 3 gemäß Anspruch 1, erhalten durch ein Verfahren, gemäß welchem die Abscheidungskammer 2 gehalten wird bei einem Druck P_{Chbre}, der zwischen 6.10⁻² und 2.10⁻¹ mbar liegt.

3. Stahlblech 3 gemäß Anspruch 1 oder 2, erhalten durch ein Verfahren, gemäß welchem der Abstand d zwischen dem oberen Teil des Schlitzes 8 der Ausstoßkammer 7 und dem zu beschichtenden Stahlblech 3 zwischen 20 und 60 mm liegt.

4. Stahlblech 3 gemäß irgendeinem der Ansprüche 1 bis 3, wobei die Zinkschicht die obere Schicht der Beschichtung ist.

5. Stahlblech 3 gemäß irgendeinem der vorhergehenden Ansprüche, wobei der beschichtete Stahl ein Ultrahochfester Stahl ist.

6. Stahlblech 3 gemäß irgendeinem der vorhergehenden Ansprüche, erhalten durch ein Verfahren, gemäß welchem die Abscheidungskammer 2 eine Eingangs-Schleuse und eine Ausgangs-Schleuse aufweist, zwischen denen das zu beschichtende Stahlblech läuft.

7. Stahlblech 3 gemäß irgendeinem der vorhergehenden Ansprüche, erhalten durch ein Verfahren, gemäß welchem die Ausstoßkammer 7 im Inneren der Abscheidungskammer 2 enthalten ist.

8. Stahlblech gemäß irgendeinem der vorhergehenden Ansprüche, erhalten durch ein Verfahren, bei dem die Ausstoßkammer 7 gegenüber der Fläche des zu beschichtenden Stahlblechs angeordnet ist.

9. Verfahren zur Herstellung eines beschichteten Stahlblechs, das aufweist das Beschichten des Blechs 3 durch einen Zink-Schalldampfstrahl mittels einer Ausstoßkammer 7, die mit einem Schlitz 8 versehen ist, wobei die Ausstoßkammer 7 unter einem Druck P_{eject} gehalten wird und im Inneren einer Abscheidungskammer 2 enthalten ist, die unter einem Druck P_{Chbre} gehalten wird, wobei das Verhältnis der Drücke P_{Chbre} durch P_{eject} zwischen 2.10⁻³ und 5,5.10⁻² liegt.

10. Verfahren gemäß Anspruch 9, wobei die Abscheidungskammer 2 unter einem P_{Chbre} gehalten wird, der zwischen 6.10⁻² und 2.10⁻¹ mbar liegt.

11. Verfahren zur Herstellung gemäß Anspruch 10, wobei der Abstand d zwischen dem oberen Teil des Schlitzes 8 der Ausstoßkammer 7 und dem zu beschichtenden Stahlblech 3 zwischen 20 und 60 mm liegt.

12. Verfahren zur Herstellung gemäß irgendeinem der Ansprüche 9 bis 11, wobei die Abscheidungskammer 2 eine Eingangs-Schleuse und eine Ausgangs-Schleuse aufweist, zwischen denen das zu beschichtende Stahlblech läuft.

13. Verfahren zur Herstellung gemäß irgendeinem der Ansprüche 9 bis 11, wobei die Ausstoßkammer 7 gegenüber der Fläche des zu beschichtenden Stahlblechs angeordnet ist.

## Claims

1. Steel sheet 3 provided with a coating comprising at least one layer of zinc obtained by a method of coating by vacuum deposition by sonic vapour jet in an installation 1 comprising a deposition chamber 2 and an ejection chamber 7 provided with an aperture 8, wherein the ratio between the pressure inside the deposition chamber 2 P_{Chbre} and the pressure inside the zinc ejection chamber 7 P_{eject} is between 2x10⁻³ and 5.5x10⁻².

2. Steel sheet 3 according to claim 1, obtained by a method in which the deposition chamber 2 is maintained at a pressure P_{Chbre} between 6x10⁻² mbar and 2x10⁻¹ mbar.

3. Steel sheet 3 according to claim 1 or 2, obtained by a method in which the distance d between the upper portion of the aperture 8 of the ejection chamber 7 and the steel sheet 3 to be coated is between 20 and 60 mm.

4. Steel sheet 3 according to any one of claims 1 to 3, wherein the layer of zinc is the top layer of the coating.

5. Steel sheet 3 according to any one of the preceding claims, wherein the coated steel is a very high strength steel.

6. Steel sheet 3 according to any one of the preceding claims, obtained by a method in which the deposition chamber 2 comprises an entry compartment and an exit compartment between which the steel sheet to be coated moves.

7. Steel sheet 3 according to any one of the preceding claims, obtained by a method in which the ejection chamber 7 is contained within the deposition chamber 2.

8. Steel sheet 3 according to any one of the preceding claims, obtained by a method in which the ejection chamber 7 is situated opposite the surface of the steel sheet to be coated.

9. Method for manufacturing a coated steel sheet 3, which comprises coating said sheet 3 by a sonic vapour jet of zinc by way of an ejection chamber 7 provided with an aperture 8, said ejection chamber 7 being maintained at a pressure P_{eject} and contained within a deposition chamber 2 maintained at a pressure P_{Chbre}, the ratio of the pressures P_{Chbre} to R_{eject} being between 2x10⁻³ and 5.5x10⁻².

10. Method according to claim 9, wherein the deposition chamber 2 is maintained at a pressure P_{Chbre} between 6x10⁻² mbar and 2x10⁻¹ mbar.

11. Manufacturing method according to claim 10, wherein the distance d between the upper portion of the aperture 8 of the ejection chamber 7 and the steel sheet 3 to be coated is between 20 and 60 mm.

12. Manufacturing method according to any one of claims 9 to 11, wherein the deposition chamber 2 comprises an entry compartment and an exit compartment between which the steel sheet to be coated moves.

13. Manufacturing method according to any one of claims 9 to 11, wherein the ejection chamber 7 is situated opposite the surface of the steel sheet to be coated.
